(19) Europäisches Patentamt
European Patent Office
Office européen des brevets

(11) Publication number: **0 354 717 A2**

(12) **EUROPEAN PATENT APPLICATION**

(21) Application number: 89307849.3

(22) Date of filing: 02.08.89

(51) Int. Cl.⁴: **H01L 23/485**

(30) Priority: **06.08.88 JP 196493/88**
**06.08.88 JP 196494/88**
**06.08.88 JP 196495/88**
**02.09.88 JP 219819/88**

(43) Date of publication of application: **14.02.90 Bulletin 90/07**

(84) Designated Contracting States: **DE FR GB NL**



(71) Applicant: **SEIKO EPSON CORPORATION**
**4-1, Nishishinjuku 2-chome**
**Shinjuku-ku Tokyo(JP)**

(72) Inventor: **Yokoyama, Kenji**
**c/o SEIKO EPSON CORPORATION 3-5 Owa 3-chome**
**Suwa-shi Nagano-ken(JP)**
Inventor: **Kato, Juri**
**c/o SEIKO EPSON CORPORATION 3-5 Owa 3-chome**
**Suwa-shi Nagano-ken(JP)**
Inventor: **Ogita, Masashi**
**c/o SEIKO EPSON CORPORATION 3-5 Owa 3-chome**
**Suwa-shi Nagano-ken(JP)**

(74) Representative: **Caro, William Egerton et al**
**J. MILLER & CO. Lincoln House 296-302 High Holborn**
**London WC1V 7JH(GB)**


(54) **Semi-conductor device and method of manufacturing such a device.**


(57) A semi-conductor device has a semi-conductor substrate (101, 301) and a connector (108, 109, 111, 308, 309, 311) separated from one another by an insulating film (102, 302) and connected to one another at a contact region by way of a contact hole formed in the insulating film. The connector includes an Al or Al alloy layer (111, 311) and a barrier layer structure (108, 109, 308, 309), the portion of the barrier layer structure in the contact region being different from the portion of the barrier layer structure on the insulating film, and the portion of the barrier layer structure in the contact region comprising a first layer (109, 309) of a refractory metal nitride and a second layer (108, 308) of a refractory metal silicide. In the manufacture of such a device, the portion of the barrier layer structure in the contact region is subjected to rapid thermal annealing at a temperature of 600°C to 1000°C to create the difference in the two portions.

107
110
(d)
109
108
111
(e)


FIG 1

EP 0 354 717 A2

102
(a)
101
104
103
(b)
106
105
(c)

FIG 1

# SEMI-CONDUCTOR DEVICE AND METHOD OF MANUFACTURING SUCH A DEVICE

The present invention concerns a semi-conductor device and a method of manufacturing such a device. In particular, the invention relates to the formation of connections in semi-conductor devices.

In known integrated circuits, connectors are provided by a dual layer structure comprising a barrier metal such as TiW or W, and an Al alloy with the Al alloy layer formed contiguous with the barrier metal layer. The connector has a portion in connection with a semi-conductor substrate formed from silicon or polycrystalline silicon or silicide within a contact hole in an insulating film, and a second portion which lies on the insulating film. In the prior art, both these portions have an identical structure.

This structure has to satisfy the two requirements of preventing reaction between the Al alloy and the Si in order to avoid spiking into the substrate and of generating a close bond with the insulating film ($SiO_2$) as the underlying layer. However, since the close bond with the insulating film is only improved when the barrier metal is readily reactive with Si, which generates spiking into the substrate, the improvement of the bond and the prevention of spiking are in a trade-off relationship and cannot simultaneously be satisfied. A further disadvantage of the prior art is that step coverage by the connector in the region of the contact hole often deteriorates and results in a disrupted connection if the size of the contact hole is less than 1 micro-metre.

According to one aspect of the present invention, there is provided a semi-conductor device having a semi-conductor substrate and a connector separated from one another by an insulating film and connected to one another at a contact region by way of a contact hole formed in the insulating film, the connector including a barrier layer structure and the semi-conductor device being characterised in that the barrier layer structure comprises a first layer of a refractory metal nitride and a second layer, which bonds the connector to the insulating film and which, in the contact region, comprises a refractory metal silicide.

The invention provides an arrangement in which the structure of the connector in the contact region is different from the structure of the connector elsewhere, i.e. on the insulating film.

As a result, it is possible to produce a highly reliable semi-conductor device with no Al spiking and with close bonding.

According to another aspect of the invention, there is provided a method of manufacturing a semi-conductor device comprising the steps of forming an insulating film on a semi-conductor substrate, forming a contact hole in the insulating film, and forming a connector on the insulating film and in the contact hole, characterised in that the step of forming the connector includes forming a first layer of a refractory metal nitride and a second layer of a refractory metal on the insulating film and in the contact hole, and subjecting the first and second layers to rapid thermal annealing at a temperature from 600 °C to 1000 °C.

The present invention will be described further, by way of example, with reference to the accompanying drawings, wherein:-

Figures 1 (a) to 1 (e) are cross sectional views illustrating the steps in the manufacture of one embodiment according to the present invention;

Figure 2 is a cross sectional view illustrating a further embodiment of the present invention;

Figure 3 (a) and 3 (b) are graphs showing the junction leak current in a semi-conductor device manufactured by the present invention and in a semi-conductor device manufactured with no rapid thermal annealing; and

Figure 4 is a graph showing electro-migration in a semi-conductor device manufactured by the present invention and in a semi-conductor device manufactured with no rapid thermal annealing.

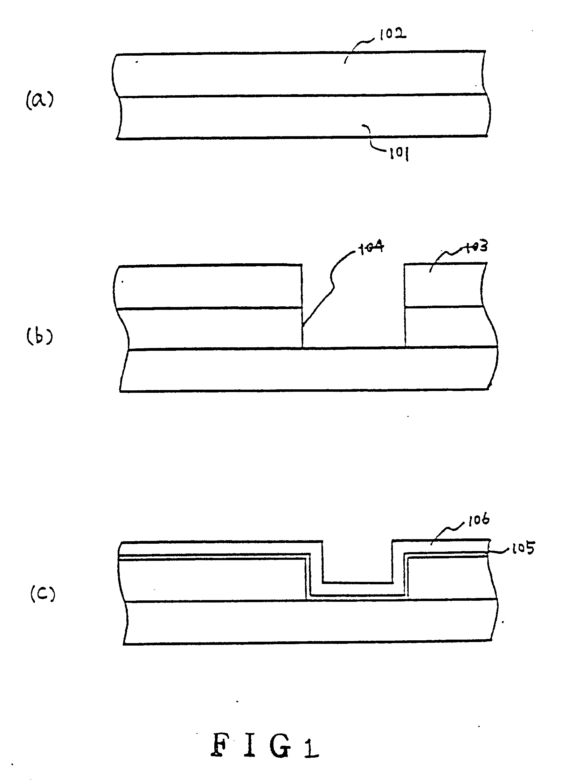

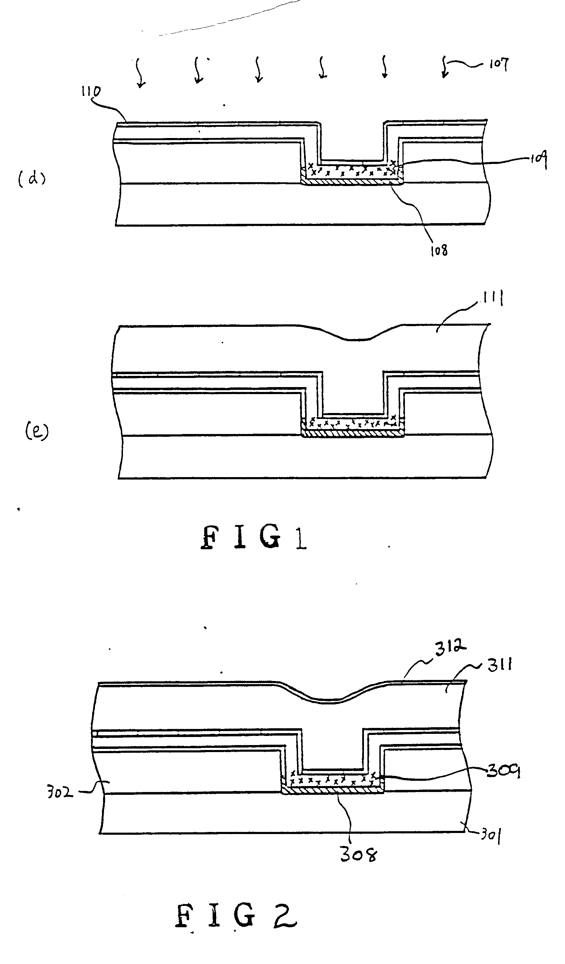

Referring to Figures 1 (a) to 1 (e), the manufacture of a first embodiment of the invention will be described.

At first, as shown in Figure 1 (a), a silicon oxide layer 102, providing an inter-layer insulating film and prepared by reacting $SiH_4$ with $O_2$ or $N_2O$ by means of plasma or heat, is formed on a semi-conductor substrate 101, which has transistors etc. provided thereon, to a thickness of about 0.3 to 0.6 micro-metres by means of gas phase growing. If flattening is required, it is desirable to provide a coating of glass, by means of spin coating, followed by heat treatment to improve the flatness.

Next, as shown in Figure 1 (b), the silicon oxide layer 102 is patterned by dry etching using $CHF_3$, for example, and a Ti photo-resist layer 103 as a mask to produce a contact hole 104.

Then, as shown in Figure 1 (c), after removing the photo-resist layer 103 used as the mask, successively a Ti layer 105 is formed on the patterned layer 102 to a thickness of 20 nm by sputtering and a TiN layer 106 is formed contiguous with the Ti layer 105 to a thickness of 100 nm by means of reactive sputtering using a Ti target in a gas mixture of Ar and $N_2$, or by means of sputtering using a TiN target.

After this, as shown in Figure 1 (d), a dual layer structure, comprising a Ti silicide layer 108 and a TiN layer 109, is generated in the contact region by fast heat treatment at a temperature from 600° C to 800° C in an $N_2$ atmosphere at an $0_2$ concentration of lower than 10 ppm. Si diffuses through into the grain boundary in the TiN layer 109 in the contact region. Also, 0 atoms intrude slighly into the surface 110 of the TiN layer 109 due to the extremely low $0_2$ concentration (lower than 10 ppm).

Then, as shown in Figure 1 (e), an Al - 0.3% Cu layer 111 is formed to a thickness of 0.8 micrometres on the TiN layer 109 by means of heat sputtering or bias sputtering at a temperature higher than 250° C. In this step, Si atoms contained in the TiN layer 109 in the contact region easily intrude into the Al - 0.3% Cu layer 111 to lower the melting point of the Al alloy and, at the same time, improve the wettability of the Al alloy. Further, since the oxygen in the TiN layer 109 and especially in the surface 110 thereof also improves the Al wettability, Al atoms can easily intrude into the contact region to provide satisfactory coverage even for a hole of sub-micron size with an aspect ratio greater than 1. Furthermore, the Si-containing TiN layer 109 prevents reaction between the Al alloy and the Si substrate.

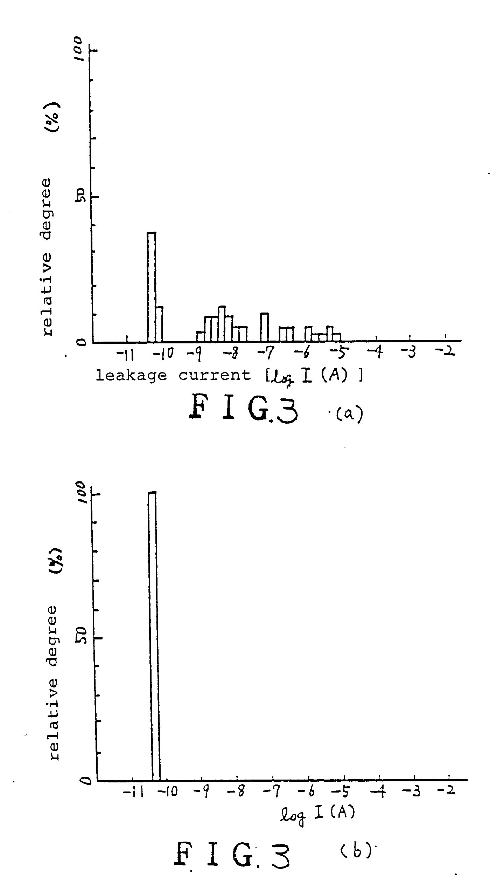

Figure 3 shows the results of measurement of the junction current leak with respect to a semiconductor device in which rapid thermal annealing is not applied (Figure 3 (a)) and a semi-conductor device according to the invention in which rapid thermal annealing is applied (Figure 3 (b)). In the latter case, the device was subjected to fast heat treatment at 700° C for thirty seconds as described above. In both cases, the device was subjected three times to thermal annealing at 450° C for thirty minutes after the formation of the Al - 0.3% Cu layer 111. In each case, the current was measured when a reverse bias voltage of 5V was applied to an $N^+$ - $P^-$ junction.

As is apparent from Figures 3 (a) and 3 (b) defects are observed in more than fifty percent of the samples not subjected to the rapid thermal annealing whereas no defects are observed in the embodiment according to the present invention. This is attributable to the prevention of the Al atoms from intruding into the Si substrate as a result of the TiN layer containing the Si atoms and the 0 atoms in the grain boundary.

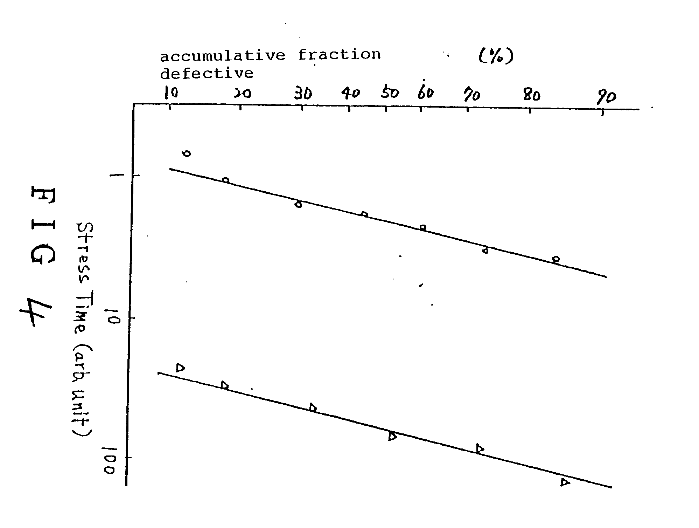

In addition, in the manufacturing method according to the present invention, disruption of the connection in the contact region due to electromigration is suppressed, which improves reliability. Figure 4 shows the results of measurements for electro-migration, in which the symbol "o" relates to devices which have not been subjected to rapid thermal annealing and the symbol " Δ " relates to an embodiment according to the present invention. As can be seen from this Figure, the semi-conductor device according to the present invention has a working life increased by about one order of magnitude by comparison with the device which has not been subjected to rapid thermal annealing.

In a variation of the embodiment shown in Figure 1, when the rapid thermal annealing is applied at 800° C to 1000° C to the Ti layer 105 on the $Si0_2$ layer 102, the Ti reacts with the 0 of the $Si0_2$ to form a Ti0 layer thereby further improving the close bond between the layer 111 and the $Si0_2$ layer 102.

A further embodiment is shown in Figure 2. This embodiment corresponds with the embodiment of Figure 1 (and similar elements are designated by references numerals which are increased by 200) with the exception that a TiN layer 312 is formed to a thickness of 30 to 50 nm on the Al - 0.3% Cu layer 311 to provide an anti-reflection layer and thereby prevent halation during a photoetching step in which the upper layers are formed into a desired connector pattern.

Although Ti has been used for the layer which is subjected to rapid thermal annealing in the above embodiments, W, Mo, Ta, etc. may also be used. Similarly, although Al - 0.3% Cu has been used as the Al alloy, another Al - Cu alloy, Al - Ti alloy, Al -Si alloy, etc. may also be employed.

As has been described above, the present invention provides a highly reliable semi-conductor device, in which reaction between an Al alloy layer and an Si substrate and the disruption of contacts due to electro-migration are avoided, and which provides a close bond between the connector layers and the interlayer insulating film, and good step coverage of the Al alloy layer.

## Claims

1. A semi-conductor device having a semiconductor substrate (101, 301) and a connector (108, 109, 111, 308, 309, 311) separated from one another by an insulating film (102, 302) and connected to one another at a contact region by way of a contact hole formed in the insulating film, the connector including a barrier layer structure (108, 109, 308, 309) and the semi-conductor device being characterised in that the barrier layer structure comprises a first layer (109, 309) of a refractory metal nitride and a second layer (108, 308), which bonds the connector to the insulating film and which, in the contact region, comprises a refractory metal silicide.

2. A semi-conductor device according to claim 1 characterised in that the second layer comprises a refractory metal in the region outside the contact region.

3. A semi-conductor device according to claim 1 characterised in that the second layer comprises a refractory metal oxide in the region outside the contact region.

4. A semi-conductor device according to any of claims 1 to 3 characterised in that the first layer contains oxygen atoms throughout its area.

5. A semi-conductor device according to any preceding claim characterised in that the first layer contains Si atoms in the contact region.

6. A semi-conductor device according to any preceding claim characterised in that the connector further includes an Al or Al alloy layer (311), and a further layer (312) of a refractory metal nitride.

7. A method of manufacturing a semi-conductor device comprising the steps of forming an insulating film (102, 302) on a semi-conductor substrate (101, 301), forming a contact hole in the insulating film, and forming a connector (108, 109, 111, 308, 309, 311) on the insulating film and in the contact hole, characterised in that the step of forming the connector includes forming a first layer of a refractory metal nitride and a second layer of a refractory metal on the insulating film and in the contact hole, and subjecting the first and second layers to rapid thermal annealing at a temperature from 600°C to 1000°C.

8. A semi-conductor device wherein a connector (108, 109, 111, 308, 309, 311) for connection with a substrate (101, 301) formed from silicon or poly-crystalline silicon or silicide comprises an Al or Al alloy layer (111, 311) and a barrier layer structure (108, 109, 308, 309) characterised in that the barrier layer structure comprises refractory metal silicide and refractory metal nitride in a contact region of the semi-conductor device, and comprises a refractory metal or refractory metal oxide and a refractory metal nitride in a region lying on an insulating film (102, 302).

9. A method of manufacturing a semi-conductor device comprising the steps of forming a contact hole in an insulating film (102, 302) on a semi-conductor substrate (101, 301), and characterised by forming a refractory metal and a refractory metal nitride on the insulating film and in the contact hole, applying rapid thermal annealing at a temperature from 600°C to 1000°C, and forming an Al or Al alloy layer (111, 311) on the refractory metal nitride.

(a)

102
101

(b)

104
103

(c)

106
105

FIG 1

107
110
(d)
109
108
111
(e)

FIG 1

312
311
309
302
301
308

FIG 2

100
50
0
(%)
relative degree
-11
-10
-9
-8
-7
-6
-5
-4
-3
-2
leakage current [log I (A) ]


FIG.3 (a)

100
50
0
(%)
relative degree
-11
-10
-9
-8
-7
-6
-5
-4
-3
-2
log I (A)


FIG.3 (b)

accumulative fraction defective (%)
90
80
70
60
50
40
30
20
10
1
10
100
Stress Time (arb unit)

FIG 4